(19) Europäisches Patentamt
European Patent Office
Office européen des brevets

(11) EP 3 936 878 B1

(12) **FASCICULE DE BREVET EUROPEEN**

(45) Date de publication et mention de la délivrance du brevet:
**28.08.2024 Bulletin 2024/35**

(21) Numéro de dépôt: **21184387.5**

(22) Date de dépôt: **07.07.2021**

(51) Classification Internationale des Brevets (IPC):
***G01R 31/392*** *(2019.01)* ***G01R 31/367*** *(2019.01)*

(52) Classification Coopérative des Brevets (CPC):
**G01R 31/392; G01R 31/367;** G01R 31/389; Y02E 60/10

(54) **PROCÉDÉ DE DÉTERMINATION D'UNE FONCTION DE VIEILLISSEMENT D'UN ACCUMULATEUR**

VERFAHREN ZUR BESTIMMUNG EINER ALTERUNGSFUNKTION EINES AKKUMULATORS

METHOD FOR DETERMINING AN AGEING FUNCTION OF AN ACCUMULATOR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.07.2020 FR 2007309**

(43) Date de publication de la demande:
**12.01.2022 Bulletin 2022/02**

(73) Titulaire: **Commissariat à l'énergie atomique et aux énergies alternatives**
**75015 Paris (FR)**

(72) Inventeurs:
- **VINIT, Laurent**
  **38054 GRENOBLE cedex 09 (FR)**
- **MONTARU, Maxime**
  **38054 GRENOBLE cedex 09 (FR)**

(74) Mandataire: **INNOV-GROUP**
**310, avenue Berthelot**
**69372 Lyon Cedex 08 (FR)**

(56) Documents cités:
**WO-A1-2017/197383**
**DE-A1- 19 540 827**
**US-A1- 2010 121 587**
**US-B1- 8 332 342**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).



Processed by Luminess, 75001 PARIS (FR)

## Description

### DOMAINE TECHNIQUE

Le domaine technique de l'invention est la prévision de l'état de santé d'une batterie.

### ART ANTERIEUR

Les batteries assurent le stockage de l'énergie sous forme chimique. Elles font l'objet d'un fort développement, et sont utilisées dans différents types d'application, par exemple pour les véhicules électriques, de type voitures ou 2 roues. Pour ce type d'application, les batteries d'accumulateurs lithium-ion constituent une option séduisante. Cependant, dans ce type d'application, les accumulateurs subissent un grand nombre de cycles de charge - décharge. Les impératifs de fiabilité nécessitent une bonne compréhension des mécanismes de vieillissement des batteries.

Le vieillissement d'une batterie comporte :

- une composante temporelle, due au temps, et usuellement désignée par les termes « dégradation calendaire » ou « vieillissement calendaire » ;
- une composante, dépendant de son utilisation, c'est-à-dire durant les différents cycles de charge et de décharge qu'elle subit. Cette composante est usuellement désignée par les termes « dégradation cyclage », ou « vieillissement en cyclage ».

Certains paramètres de fonctionnement sont considérés comme ayant un effet prédominant sur la dégradation cyclage. Il s'agit par exemple de la température, de la charge totale échangée par la batterie au cours des différents cycles, ou de l'évolution temporelle de l'état de charge. La publication Gewald T. « Accelerated aging characterization of Lithium-ion cells : using sensitivity analysis to identify the stress factors relevant to cyclic aging », Batteries 2020, 6, 6, décrit les principaux paramètres ayant une influence sur la dégradation cyclage.

Le vieillissement se traduit par une diminution de la capacité de la batterie. On peut le quantifier par un indicateur d'état de santé (SOH - State of Health), ce dernier étant représentatif d'une variation de la capacité de la batterie entre un instant initial et un instant postérieur à l'instant initial. L'état de santé de la batterie est usuellement quantifié par un ratio entre la capacité, à un instant donné, et la capacité initiale de la batterie. Il peut également être quantifié par un ratio entre la résistance, à un instant donné, et la résistance initiale de la batterie, ou un ratio d'énergie disponible en décharge.

L'analyse de l'influence des paramètres de fonctionnement sur le vieillissement suppose généralement une phase expérimentale, au cours de laquelle un accumulateur, ou un groupe d'accumulateurs, est connecté électriquement à un banc d'essais. On peut ainsi mesurer l'état de santé de la batterie en fonction d'un profil d'utilisation de la batterie, ce dernier correspondant à différents cycles de charge ou de décharge successifs.

Afin de pouvoir prévoir le vieillissement, il est utile de disposer d'une fonction de vieillissement, permettant d'estimer le vieillissement en fonction de paramètres de fonctionnement. La publication Sarakesta-Zabala et Al., «Cycle ageing analysis of a LiFePO4/graphite cell with dynamic model validations : towards realistic lifetime prédictions », Journal of power sources 275 (2015) 573-587, décrit par exemple l'établissement d'une fonction de vieillissement, quantifiant le vieillissement en fonction de la profondeur de décharge totale et de la charge totale s'étant écoulée à travers la batterie.

Le document US8332342 propose un modèle analytique permettant un suivi de l'état d'une batterie. Ce modèle analytique ne prend pas en compte la profondeur de décharge en tant que variable.

Le document US2010121587 adresse la question de la détermination de la durée de vie et de la capacité résiduelle d'une batterie, en prenant en compte une profondeur de décharge fixe, ou moyenne, au cours de différents cycles de charge-décharge. La profondeur de décharge n'est pas prise en compte en tant que variable d'une fonction permettant d'estimer le vieillissement de la batterie.

Le document DE19540827 décrit une évaluation du vieillissement d'une batterie en assignant un nombre maximal de cycles lorsque la batterie est soumise à des cycles de charge/décharge ayant une même profondeur de décharge. Pour différentes profondeurs de décharge, un nombre maximal de cycles est ainsi déterminé. Lorsqu'une batterie subit successivement différents cycles, de différentes profondeurs de décharge, la durée de vie de la batterie est estimée en pondérant le nombre maximal de cycles assigné à chaque profondeur de décharge par les fréquences d'occurrences respectives des différentes profondeurs de décharge.

Les inventeurs ont constaté certaines limites à l'utilisation des fonctions de vieillissement précédemment évoquées. Ils proposent une autre approche, considérée comme plus précise et plus simple d'utilisation.

## EXPOSE DE L'INVENTION

Un premier objet de l'invention est un procédé de détermination d'une fonction de vieillissement cyclage d'un accumulateur, ou d'un groupe d'accumulateurs, tel que défini par la revendication indépendante 1.

Ainsi, la fonction de vieillissement dépend à la fois de l'état de charge et de la profondeur de décharge en différents instants, au cours de cycles de charge/décharge.

Par fonction de vieillissement, on entend une fonction représentative d'une variation de la capacité ou de la résistance de l'accumulateur. La fonction de vieillissement peut comporter une composante de vieillissement cyclage, et éventuellement une composante de vieillissement calendaire.

La fonction de vieillissement peut déterminer :

- une baisse de la capacité de l'accumulateur, ou du groupe d'accumulateurs, au cours d'une utilisation de l'accumulateur ;
- une augmentation de la résistance de l'accumulateur, ou du groupe d'accumulateurs, au cours de l'utilisation de l'accumulateur.

Selon un mode de réalisation, les variables de la fonction de vieillissement comprennent, outre la profondeur de décharge et l'état de charge : la température et/ou l'intensité de charge ou de décharge et/ou la charge totale échangée par l'accumulateur. Les variables de la fonction de vieillissement peuvent être au moins l'intensité de charge ou de décharge, l'état de charge et la profondeur de décharge.

De préférence, le procédé comporte, en différents instants de mesure de chaque cycle, une détermination d'une valeur de profondeur de décharge. Le procédé peut être tel que les instants de mesure étant classés par ordre chronologique à partir d'un instant initial, le procédé comporte, pour chaque instant de mesure postérieur à deux instants de mesure suivant l'instant initial :

- comparaison de l'état de charge lors de l'instant de mesure avec les états de charge respectifs lors de l'instant de mesure précédent et l'avant-dernier instant de mesure ;
- lorsque la comparaison indique que l'état de charge suit une évolution monotone, croissante ou décroissante, entre l'avant-dernier instant de mesure et l'instant de mesure, incrémentation de la valeur de la profondeur de décharge à l'instant de mesure, en fonction de la valeur de la profondeur de décharge à l'instant de mesure précédent ;
- lorsque la comparaison n'indique pas que l'état de charge suit une évolution monotone, croissante ou décroissante, entre l'avant-dernier instant de mesure et l'instant de mesure, réinitialisation de la valeur de la profondeur de décharge à l'instant de mesure.

Selon un mode de réalisation :

- les étapes a) et b) peuvent être mises en oeuvre en utilisant successivement différents accumulateurs de test ;
- chaque cycle de charge/décharge s'étend entre une charge initiale et une charge finale, définissant une profondeur de décharge du cycle;
- au moins deux accumulateurs de test différents sont soumis à des cycles de charge définissant une profondeur de décharge totale différente.

De préférence, au moins deux accumulateurs de test différents sont soumis à des cycles de charge dont la charge initiale et la charge finale sont différentes.

Un deuxième objet de l'invention est un procédé d'estimation du vieillissement d'un accumulateur tel que défini par la revendication 8.

Selon un mode de réalisation, les instants d'estimation sont classés par ordre chronologique à partir d'un instant d'estimation initial ; le procédé comporte, lors de chaque instant d'estimation postérieur à deux instants d'estimation après l'instant initial :

- comparaison de l'état de charge lors de l'instant d'estimation avec les états de charge respectifs lors de l'instant d'estimation précédent et l'avant-dernier instant d'estimation ;
- lorsque la comparaison indique que l'état de charge suit une évolution monotone, croissante ou décroissante, entre l'avant-dernier instant d'estimation et l'instant d'estimation, incrémentation de la valeur de la profondeur de décharge à l'instant d'estimation, en fonction de la valeur de la profondeur de décharge à l'instant d'estimation précédent ;
- lorsque la comparaison n'indique pas que l'état de charge suit une évolution monotone, croissante ou décroissante, entre l'avant-dernier instant d'estimation et l'instant d'estimation, réinitialisation de la valeur de la profondeur de décharge à l'instant d'estimation

Un troisième objet de l'invention est un dispositif de modélisation du vieillissement d'un accumulateur tel que défini par la revendication indépendante 10.

L'invention sera mieux comprise à la lecture de l'exposé des exemples de réalisation présentés, dans la suite de la description, en lien avec les figures listées ci-dessous.

## FIGURES

La figure 1A schématise une batterie d'accumulateurs.
La figure 1B représente un banc d'essai destiné à recevoir un accumulateur ou un groupe d'accumulateurs.
La figure 2A montre les principales étapes d'un procédé de détermination d'une fonction de vieillissement d'un accumulateur.
La figure 2B détaille une étape de détermination d'une profondeur de décharge en un instant de mesure.
La figure 2C montre les principales étapes d'un procédé d'estimation du vieillissement d'un accumulateur sur la base d'une fonction de vieillissement préalablement établie.
La figure 3A représente une évolution d'une capacité d'un accumulateur en fonction de la charge totale échangée par l'accumulateur, au cours de différents cycles de charge/décharge, les capacités étant respectivement mesurées et simulées. Les capacités simulées sont obtenues en utilisant une fonction de vieillissement ne prenant pas en compte la profondeur de décharge.
La figure 3B montre des erreurs relatives entre des capacités mesurées et estimées représentées sur la figure 3A.
La figure 3C représente une évolution d'une capacité d'un accumulateur en fonction de la charge totale échangée par l'accumulateur, au cours de différents cycles de charge/décharge, les capacités étant respectivement mesurées et simulées. Les capacités simulées sont obtenues en utilisant une fonction de vieillissement dont une variable est la profondeur de décharge.
La figure 3D montre des erreurs relatives entre des capacités mesurées et estimées représentées sur la figure 3C.
Les figures 4A et 4B sont des représentations de fonctions de vieillissement, dont les variables sont respectivement l'état de charge et la profondeur de décharge.

## EXPOSE DE MODES DE REALISATION PARTICULIERS

La figure 1A représente une batterie 10, formée d'un groupe d'accumulateurs 1. Chaque accumulateur 1 comporte un électrolyte relié à deux électrodes. L'accumulateur définit un système électrochimique réversible, permettant une conversion entre une énergie chimique et une énergie électrique et réciproquement. Dans l'exemple représenté, l'accumulateur est de type Lithium ion, l'électrolyte étant un solvant organique à base de sel de lithium.

Comme décrit dans l'art antérieur, il est utile d'évaluer le vieillissement de la batterie, notamment en fonction d'une sollicitation prévisible de la batterie. Pour cela, un accumulateur de la batterie, ou un groupe d'accumulateurs, fait l'objet d'essais expérimentaux, de façon à déterminer une fonction représentative d'un vieillissement de l'accumulateur ou du groupe d'accumulateurs.

Comme décrit en lien avec l'art antérieur, le vieillissement d'un accumulateur se traduit par une diminution progressive de la capacité, ou d'une augmentation progressive de la résistance. A un instant *t,* la capacité $C(t)$ correspond à la quantité de charges obtenue lors d'une décharge complète de l'accumulateur. Elle est usuellement exprimée en Ah (Ampère heure). Le vieillissement se traduit par une variation de la capacité de stockage $\Delta C(t)$ à partir d'une capacité initiale $C_0$. Il peut également se traduire par une variation de la résistance de l'accumulateur $\Delta R(t)$ à partir d'une résistance initiale $R_0$.

Dans l'exemple détaillé qui suit, la fonction de vieillissement correspond à une variation de la capacité au cours de l'utilisation de l'accumulateur. L'invention couvre également l'établissement et l'utilisation d'une fonction de vieillissement correspondant à une variation de la résistance au cours de l'utilisation de l'accumulateur.

Comme décrit en lien avec l'art antérieur, un accumulateur subit généralement un vieillissement calendaire, dépendant du temps, pouvant être exprimé par l'expression :

$$\frac{d(\Delta C(t))}{dt} = \frac{g(T(t), SOC(t))}{1 + A\Delta C(t)} \quad (1)$$

où :

- *SOC*(*t*), acronyme du terme anglosaxon State Of Charge, est l'état de charge, qui correspond à la quantité de charges disponibles dans l'accumulateur, à un instant *t* relativement à la capacité de la batterie. La valeur de *SOC(t)* est comprise entre 0% et 100%. Lors de la charge, l'état de charge est une fonction croissante. Lors de la décharge, l'état de charge est une fonction décroissante ;

- *T*(*t*) est une température de fonctionnement de la batterie ;
- *g* est une fonction empirique, dépendant de la température et de l'état de charge ;
- *A* est une constante positive, parfois désignée facteur de forme.

La quantité $\frac{d(\Delta C(t))}{dt}$ correspond à une vitesse de dégradation de l'accumulateur liée au vieillissement calendaire. Elle peut être exprimée en $Ah.s^{-1}$.

L'accumulateur subit également un vieillissement de cyclage, pouvant être exprimé par l'expression :

$$\frac{d\big(\Delta C(t)\big)}{dQ_{tot}} = \frac{h(T(t), SOC(t), I(t))}{1 + A\Delta C(t)} \quad (2)$$

où :

- *I*(*t*) est l'intensité du courant de charge ou de décharge à un instant *t*;
- $Q_{tot}(t)$ est la charge totale transitée à travers l'accumulateur au cours des différents cycles de charge et décharge successifs, depuis un instant initial, jusqu'à l'instant *t*;
- *h* est une fonction empirique, dépendant de la température de fonctionnement, de l'état de charge et de l'intensité du courant de charge ou de décharge de l'accumulateur.

La grandeur $\frac{d\big(\Delta C(t)\big)}{dQ_{tot}}$ correspond à une vitesse de dégradation de l'accumulateur liée au vieillissement cyclage, c'est-à-dire en fonction de la charge totale échangée par l'accumulateur. L'expression (2) montre que la variation de capacité, l'intensité du courant, la charge totale échangée et la température sont usuellement considérés comme les paramètres les plus influents sur le vieillissement cyclage de l'accumulateur.

A partir de (1) et de (2), il est possible de prévoir une variation de la capacité de l'accumulateur, selon l'expression :

$$\Delta C(t) = \frac{d(\Delta C(t))}{dt}dt + \frac{d\big(\Delta C(t)\big)}{dQ_{tot}}dQ_{tot} \quad (3)$$

Les fonctions empiriques *g* et *h* sont généralement obtenues expérimentalement, en utilisant un banc d'essai. La figure 1B schématise un banc d'essai 20, destiné à placer un accumulateur, ou un groupe d'accumulateurs, dans différent états de charge, déterminés à l'avance, et à mesurer des paramètres de fonctionnement de l'accumulateur ou du groupe d'accumulateurs. Dans la suite de la description, il est supposé que le banc d'essai comporte un accumulateur, sachant qu'il peut comporter un groupe d'accumulateurs. Les différents états de charge suivent un profil temporel de sollicitation, comportant différents cycles successifs de charge et décharge, et éventuellement des phases de pause. La mesure de paramètres de fonctionnement durant les cycles permet de définir expérimentalement les fonctions empiriques *g* et *h*.

Le banc d'essai 20 comprend un circuit de charge 21, destiné à adresser un courant de charge $I_{CH}$ à l'accumulateur au cours de chaque cycle de charge. Le circuit de charge 21 comporte une alimentation électrique 22 générant le courant de charge $I_{CH}$. Le banc d'essai 20 comporte également un circuit de décharge 23 dans lequel circule un courant de décharge $I_{DCH}$ de la batterie. Le circuit de décharge comporte, dans cet exemple, une résistance 24.

Le banc d'essai 20 comporte un circuit électrique de mesure 25, configuré pour mesurer une intensité et/ou une tension du courant électrique circulant entre des bornes 2 de l'accumulateur. Le banc d'essai comporte également un capteur de température 26.

Le banc d'essai comporte une unité de commande 27, permettant de piloter les cycles de charge et de décharge de l'accumulateur. L'unité de commande peut être un ordinateur industriel permettant la visualisation et l'enregistrement des résultats d'essais.

Le banc d'essai 20 est relié à une unité de traitement 30, configurée pour mettre en oeuvre l'invention. L'unité de traitement comporte un microprocesseur. L'unité de traitement est configurée pour paramétrer les cycles de charge / décharge de l'accumulateur, et pour établir une fonction de vieillissement de l'accumulateur à partir des paramètres de fonctionnement mesurés au cours des cycles de charge et de décharge. L'unité de traitement 30 permet également d'estimer des paramètres de fonctionnement à partir des données mesurées par le banc d'essai 20. Il s'agit par exemple de l'état de charge, ce dernier étant déterminé à partir de la capacité de l'accumulateur et de l'intensité du courant de charge ou de décharge. Il s'agit également de la charge totale échangée par l'accumulateur. Selon une possibilité, l'état de charge et la charge totale échangée sont directement estimés par le circuit de mesure 25.

Au cours de chaque cycle de charge / décharge, le banc d'essai 20 permet une mesure régulière de paramètres de fonctionnement de l'accumulateur 1. Ainsi, en différents instants de mesure *t*, postérieurs à un instant initial $t_0$, le banc d'essai 20 permet de mesurer les paramètres de fonctionnement, comme décrit ci-après. A partir des mesures effectuées par le banc d'essai, les fonctions empiriques *g* et/ou *h* sont obtenues.

Les inventeurs ont constaté qu'il est préférable que le vieillissement cyclage d'un accumulateur soit exprimé en fonction de l'état de charge *SOC*(*t*), mais également en fonction de la profondeur de décharge *DOD* (*t*), et cela en différents instants *t*. La profondeur de décharge *DOD(t)* (acronyme du terme anglosaxon Depth of Discharge), correspond :

- lors d'une décharge, au pourcentage de la charge ayant été débité par l'accumulateur ;
- lors d'une charge, au pourcentage de la charge ayant été restaurée dans l'accumulateur.

Ainsi, en partant de (2), le vieillissement cyclage peut être exprimé de telle sorte que :

$$\frac{d\left(\Delta C(t)\right)}{dQ_{tot}} = \frac{h(T, SOC, I, DOD)}{1 + A\Delta C(t)} \quad (4)$$

Selon cette approche, la fonction de vieillissement, c'est-à-dire la fonction $\frac{d\left(\Delta C(t)\right)}{dQ_{tot}}$ comporte une fonction empirique *h*(*T, SOC, I, DOD*), dont les variables sont la température, l'état de charge, l'intensité de charge ou de décharge, ainsi que la profondeur de décharge.

La fonction de vieillissement peut être établie expérimentalement, en suivant les étapes décrites en lien avec les figures 2A et 2B. A cette fin, on utilise un accumulateur de test, connecté à un banc d'essai 20, tel que décrit en lien avec la figure 1B. L'accumulateur de test est représentatif du type d'accumulateur dont on souhaite étudier le vieillissement. Il est soumis à différents cycles de charge et de décharge. L'objectif est d'obtenir la fonction empirique *h*, prenant en compte, en différents instants de chaque cycle, à la fois au moins l'état de charge *SOC* et la profondeur de décharge *DOD*.

Etape 100 : Initialisation. Cette étape est mise en oeuvre à un instant initial $t_0$. Au cours de cette étape, un profil de sollicitation est défini, qui correspond à différents cycles de charge et de décharge de l'accumulateur ainsi que certains paramètres de fonctionnement de l'accumulateur, par exemple la température.

Chaque charge et chaque décharge peut être paramétrée par un état de charge initial $SOC(t_{init})$ et un état de charge final $SOC(t_{end})$. Au cours d'une charge ou d'une décharge, la profondeur de décharge totale $DOD_{tot}$ correspond à la valeur absolue de la différence entre l'état de charge initial et l'état de charge final : Ainsi,

$$DOD_{tot} = \left|SOC(t_{init}) - SOC(t_{end})\right| \quad (5)$$

Lors de la phase expérimentale, réalisée sur le banc d'essai, il est préférable que le profil de sollicitation, auquel est soumis l'accumulateur, soit tel que :

- l'état de charge initial $SOC(t_{init})$ des différentes charges et décharges soit variable ;
- et/ou l'état de charge final $SOC(t_{end})$ des différentes charges et décharges soit variable ;
- la profondeur de décharge totale $DOD_{tot}$ des différentes charges et décharges soit variable.

De préférence, on effectue des essais en utilisant successivement différents accumulateurs de test, ces derniers étant représentatifs de l'accumulateur que l'on souhaite caractériser. Un même accumulateur de test est de préférence soumis à des cycles de charge/décharge entre un même état de charge initial et un même état de charge final, ce qui se traduit par une même profondeur de décharge totale. Différents accumulateurs de test sont soumis à différents cycles, en modifiant, entre deux accumulateurs de test différents, l'état de charge initial et/ou l'état de charge final et/ou la profondeur de décharge totale.

Les étapes 110 et 120 sont mises en oeuvre à différents instants de mesure *t*, au cours des charges et décharges. Deux instants de mesure successifs *t, t* + 1 peuvent être espacés les uns des autres d'une durée généralement comprise entre quelques secondes, par exemple 10 s, et quelques minutes.

Etape 110 : mesure de paramètres de fonctionnement à chaque instant de mesure.

A chaque instant de mesure t on détermine, à partir du banc d'essai, des paramètres de fonctionnement de l'accumulateur, qui constituent des variables de la fonction de vieillissement. Il s'agit notamment de *I*(*t*), *SOC*(*t*), *T*(*t*). On suppose qu'au cours d'un même cycle charge/décharge, la capacité C(t) de l'accumulateur est constante. A partir des valeurs d'intensité *I*(*t*) mesurées, les paramètres de fonctionnement *SOC*(*t*). $Q_{tot}(t)$ sont calculés. La capacité *C*(*t*) est vérifiée périodiquement.

Etape 120 : détermination de la profondeur de décharge *DOD*(*t*) à l'instant de mesure *t.*

Cette étape suppose une connaissance des deux précédents états de charge, c'est-à-dire les états de charge aux instants *t* - 1 et *t* - 2. Aussi, la mise en oeuvre de l'étape 120 suppose que l'étape 110 ait été mise en oeuvre à au moins deux instants précédents l'instant de mesure *t.* Au cours de cette étape, à partir de l'état de charge *SOC*(*t*), déterminé à l'instant de mesure *t,* et des états de charge *SOC*(*t* - 1), et *SOC*(*t* - 2), on détermine la profondeur de décharge *DOD*(*t*).

L'étape 120 comporte des sous-étapes 121 à 123, schématisées sur la figure 2B.

Au cours de la sous-étape 121, on détermine un sens de variation de l'état de charge. Il s'agit de savoir si l'accumulateur subit une charge, ou une décharge, ou est dans un état transitoire entre une charge et une décharge ou dans un état de pause.

L'étape 121 comporte une comparaison des états de charge aux instants *t, t* - 1 (dernier instant avant l'instant t) et *t* - 2 (avant-dernier instant). Lorsque les états de charge, pris dans l'ordre chronologique, suivent une fonction monotone, qu'elle soit croissante ou décroissante, l'accumulateur subit soit une charge, soit une décharge :

- lorsque *SOC*(*t* - 2) < *SOC* (*t* - 1) < *SOC(t)* (6), l'état de charge suit une fonction croissante, ce qui correspond à une charge ;
- lorsque *SOC*(*t* - 2) > *SOC* (*t* - 1) > *SOC*(*t*) (7), l'état de charge suit une fonction décroissante, ce qui correspond à une décharge.

Lorsqu'une des conditions (6) ou (7) est respectée, on met en oeuvre une étape 122 de mise à jour de la profondeur de décharge *DOD*(*t*), selon l'expression :

$$DOD(t) = DOD(t-1) + \ |SOC(t) - SOC(t-1)| \quad (8)$$

Lorsqu'aucune des conditions (6) et (7) n'est respectée, on met en oeuvre une étape 123 de réinitialisation de la profondeur de décharge *DOD(t),* selon l'expression :

$$DOD(t) = \ |SOC(t) - SOC(t-1)| \quad (9)$$

On note qu'au cours d'une charge ou au cours d'une décharge, la profondeur de décharge est une fonction croissante, l'expression (8) impliquant *DOD*(*t*) > *DOD*(*t* - 1).

L'étape 120 permet une détermination de la profondeur de décharge à chaque instant de mesure.

Etape 130 : réitération

Au cours de cette étape, l'instant de mesure *t* est incrémenté. Les étapes 110 à 120 sont alors répétées jusqu'à l'issue des itérations. L'issue des itérations peut correspondre à la fin du profil de sollicitation auquel est soumis l'accumulateur dans le banc d'essai.

Etape 140 : optimisation

A l'issue des itérations, on dispose, à chaque instant de mesure, des paramètres *T*(*t*),*SOC*(*t*), *DOD*(*t*), $Q_{tot}(t)$, *I*(*t*) et $\Delta C(t)$. Un algorithme d'optimisation permet de déterminer une fonction empirique *h*, de telle sorte que :

$$\frac{d(\Delta C)}{dQ_{tot}} = \frac{h(T, SOC, I, DOD)}{1 + A\Delta C} \quad (10)$$

L'algorithme d'optimisation peut également estimer une valeur de la constante *A*. L'algorithme d'optimisation permet de minimiser un écart entre les valeurs $\frac{d(\Delta C(t))}{dQ_{tot}}$ respectivement mesurées et estimées par l'expression (10). L'algorithme d'optimisation peut être un algorithme récursif, de type moindres carrés récursifs ou filtre de Kalman. Il peut également s'agir d'un algorithme d'intelligence artificielle, de type réseau de neurones.

La fonction empirique *h* peut être de forme prédéterminée, sur la base d'un modèle de batterie, reliant la tension aux bornes de la batterie, l'état de charge et le courant de charge ou de décharge.

De façon alternative, la fonction empirique *h* est déterminée, pour différentes valeurs que prennent les paramètres de fonctionnement *T*,*SOC*,*I* et *DOD* durant les cycles de charge/décharge expérimentaux. Le procédé peut comporter une phase d'interpolation, au cours de laquelle la fonction empirique *h* est déterminée entre différentes valeurs d'un même paramètres.

A l'issue de l'étape 140, on dispose d'une fonction de vieillissement $\frac{d(\Delta C)}{dQ_{tot}}$, représentative du vieillissement cyclage de la batterie.

Selon une variante, la fonction de vieillissement est exprimée par un produit de deux fonctions empiriques $h_1$ et $h_2$, selon l'expression (10') :

$$\frac{d(\Delta C)}{dQ_{tot}} = \frac{h_1(T,SOC,I)h_2(T,DOD)}{1+A\Delta C} \quad (10)'$$

Les étapes 100 à 140 correspondent à un procédé de détermination de la fonction de vieillissement cyclage $\frac{d(\Delta C)}{dQ_{tot}}$. Cette dernière peut être combinée à une fonction de vieillissement calendaire, telle qu'exprimée dans l'expression (1), de façon à obtenir une estimation d'une variation de la capacité de l'accumulateur, selon l'expression (3).

Il est alors possible d'estimer un vieillissement de l'accumulateur en fonction de différentes conditions d'utilisation. Les conditions d'utilisation sont définies selon les paramètres de fonctionnement de la batterie : température, états de charge, intensité de charge ou de décharge. Les conditions d'utilisation, ainsi que la fonction de vieillissement, constituent les données d'entrée de l'estimation. Le procédé d'estimation comporte ainsi les étapes suivantes :

Etape 200 : définition des conditions d'utilisation : nombre de cycles, états de charge minimal et maximal de chaque cycle. L'utilisation définie s'étend selon une plage temporelle d'utilisation, au cours de laquelle s'écoulent les cycles de charge et de décharge.

Etape 205 : segmentation de l'estimation en différents instants d'estimation *t'*, durant la plage temporelle d'utilisation.

Les étapes 210 à 230 sont mises en oeuvre de façon itérative, à chaque instant d'estimation *t'*.

Etape 210 : à chaque instant d'estimation *t'*, définition des paramètres de fonctionnement de l'accumulateur en fonction des conditions d'utilisation définies lors de l'étape 200. Les paramètres de fonctionnement sont par exemple $I(t')$, $SPC(t')$, $T(t')$, $Q_{tot}(t')$.

Etape 220 : détermination de la profondeur de décharge $DOD(t')$ au cours de chaque instant d'estimation *t'*. L'étape 220 est similaire à l'étape 120 décrite en lien avec les figures 2A et 2B, les instants de mesure *t* étant remplacés par des instants d'estimation *t'*.

Etape 230 : en fonction des paramètres de fonctionnement, incluant la profondeur de décharge, à chaque instant d'estimation *t'*, détermination d'une variation de la capacité de l'accumulateur en utilisant la fonction de vieillissement.

Etape 240 : incrémentation de l'instant d'estimation *t'*, jusqu'à une sortie de l'algorithme. La sortie de l'algorithme correspond au dernier instant d'estimation, à l'issue de la plage temporelle d'utilisation.

Dans l'exemple précédemment décrit, la fonction de vieillissement représente une variation de la capacité d'un accumulateur. L'invention s'applique également pour un groupe d'accumulateurs ou d'autres types de fonctions de vieillissement.

On sait que le vieillissement d'un accumulateur, ou d'un groupe d'accumulateurs, se traduit par une augmentation de la résistance. Aussi, selon une variante, la fonction de vieillissement traduit une variation de la résistance en fonction du temps (vieillissement calendaire) et en fonction des cycles de charge et décharge de l'accumulateur (vieillissement cyclage). La variation de la résistance due au vieillissement cyclage peut être modélisée comme décrit en lien avec les étapes 100 à 140. Elle peut ensuite être mise en oeuvre, à des fins de prévision, comme décrit en lien avec les étapes 200 à 240.

Essais expérimentaux.

Les inventeurs ont placé successivement des accumulateurs de test, représentatifs d'un accumulateur d'une batterie Lithium ion, dans un banc d'essai de type Digatron, pour effectuer des essais d'endurance. La température de l'accumulateur a été maintenue constante à 45°C. Au cours de différents essais, les accumulateurs de test ont subi différents cycles de charge/décharge dont les paramètres sont listés dans le tableau 1.

Tableau 1

| Référence essai | SOCmin (%) | SOCmax (%) | DOD (%) |
|---|---|---|---|
| 1 | 47.5 | 52.5 | 5 |
| 2 | 0 | 40 | 40 |
| 3 | 40 | 70 | 30 |
| 4 | 70 | 100 | 30 |
| 5 | 0 | 100 | 100 |

Chaque charge est effectuée selon un régime de charge de C/2, ce qui signifie que l'accumulateur est complètement rechargé en 2 heures. Chaque décharge était effectuée selon un régime 1C, ce qui signifie que l'accumulateur était complètement déchargé en 1 heure.

Au cours de chaque essai, on a déterminé deux fonctions de vieillissement : une fonction de vieillissement établie sans prise en compte de la profondeur de décharge, selon l'expression (2), et une fonction de vieillissement dont une variable est la profondeur de décharge, mesurée au cours de chaque cycle, selon l'expression (10). La fonction de vieillissement prenant en compte la profondeur de décharge a été établie en suivant les étapes 100 à 140 précédemment décrites, de façon à obtenir une composante de vieillissement due au cyclage.

La figure 3A montre, pour chaque essai, des variations de la capacité respectivement mesurées (marques discrètes) et modélisées par une fonction de vieillissement ne prenant pas en compte la profondeur de décharge. L'axe des abscisses correspond à la charge totale $Q_{tot}$ échangée par l'accumulateur (unité Ah) tandis que l'axe des ordonnées correspond à la capacité $C$ de l'accumulateur (unité Ah). La figure 3B représente l'évolution de l'erreur relative d'estimation de la capacité en fonction de la charge totale $Q_{tot}$ échangée par l'accumulateur. L'erreur relative d'estimation, exprimée en %, correspond à une comparaison entre l'estimation de la capacité C de l'accumulateur, par la fonction de vieillissement et la capacité réellement mesurée. La comparaison est normalisée par la capacité mesurée.

La figure 3C montre, pour chaque essai, des variations de la capacité respectivement mesurées (marques discrètes) et modélisées par une fonction de vieillissement dont les variables comprennent à la fois l'état de charge et la profondeur de décharge. L'axe des abscisses correspond à la charge totale $Q_{tot}$ échangée par l'accumulateur (unité Ah) tandis que l'axe des ordonnées correspond à la capacité $C$ de l'accumulateur (unité Ah). La figure 3D représente l'évolution de l'erreur relative d'estimation de la capacité en fonction de la charge totale $Q_{tot}$ échangée par l'accumulateur, comme décrit en lien avec la figure 3B.

Les figures 3A et 3C montrent que la trajectoire de dégradation, c'est-à-dire l'évolution de la capacité en fonction de la charge totale échangée, dépend à la fois de la profondeur de décharge et des états de charges minimal et maximal de chaque cycle. Les essais référencés 3 et 4 correspondent à une même profondeur de décharge (30 %) mais à des états de charge minimal et maximal différents, respectivement, respectivement 40% - 70% et 70% - 100 %. La trajectoire de dégradation respectivement associée aux essais 3 et 4 est pourtant significativement différente. Cela montre qu'il est pertinent que la fonction de vieillissement dépende à la fois de l'état de charge et de la profondeur de décharge.

Par ailleurs, la comparaison des figures 3B et 3D montrent qu'en se basant sur une fonction de vieillissement dépendant de l'état de charge et la profondeur de décharge, l'erreur d'estimation est significativement réduite, et cela pour chaque essai réalisé. La variation de la capacité de la batterie est estimée de façon plus précise, ce qui atteste de la pertinence de l'approche suivie par les inventeurs.

Ainsi, la prise en compte de la profondeur de décharge et de l'état de charge, en différents instants de mesure dans chaque cycle, permet une meilleure évaluation du vieillissement cyclage. Bien que la profondeur de décharge et l'état de charge soient des grandeurs reliées l'une à l'autre par une relation additive, la fonction de vieillissement cyclage est définie en combinant ces deux variables, la combinaison étant définie de façon empirique, et non par une simple relation analytique.

Lors de la mise en oeuvre des essais, les inventeurs ont établis des fonctions empiriques $h_1$ et $h_2$ telles que décrites en lien avec l'expression (10'). Le produit des fonctions empiriques $h_1$ et $h_2$ correspond à la fonction empirique *h* décrite en lien avec les étapes 100 à 140. Les figures 4A et 4B montrent différentes valeurs respectivement prises par les fonctions $h_1$ et $h_2$ pour une même intensité de charge, respectivement en fonction de l'état de charge (axe des abscisses de la figure 4A) et de la profondeur de décharge (axe des abscisses de la figure 4B).

La fonction $h_1$ est une fonction empirique telle que décrite dans l'expression (2). La fonction $h_2$ peut être considérée comme un correctif appliqué à la fonction $h_1$, prenant en compte de la profondeur de décharge pour établir la fonction de vieillissement.

En pratique, une fonction empirique *h*, telle que précédemment décrite peut être représentée dans un espace dont la dimension dépend du nombre de variables. Dans l'exemple expérimental décrit, la température était maintenue fixe. La fonction empirique *h* dépend alors de 3 variables, correspondant respectivement à l'intensité charge et de décharge (l'intensité de charge étant de signe opposée à l'intensité de décharge), l'état de charge et la profondeur de décharge.

L'invention pourra être mise en oeuvre pour paramétrer des systèmes de gestion de batteries (BMS - Battery Management System), de façon à prévoir et optimiser la durée de batteries. Bien que décrite, dans cet exemple, en lien avec une batterie de type Lithium ion, l'invention peut s'appliquer à d'autres types de batteries.

## Revendications

1. Procédé de détermination d'une fonction de vieillissement cyclage ( $\frac{d(\Delta C)}{dQ_{tot}}$ , $\Delta C(t)$) d'un accumulateur (1), ou d'un groupe d'accumulateurs, la fonction de vieillissement cyclage représentant une évolution de la capacité ou de la résistance de l'accumulateur, ou du groupe d'accumulateurs au cours de l'utilisation de l'accumulateur ou du groupe d'accumulateurs, la fonction de vieillissement cyclage étant définie en fonction de variables représentatives du fonctionnement de l'accumulateur, le procédé comportant :

   - a) réalisation de plusieurs cycles expérimentaux de charge et de décharge d'au moins un accumulateur de test, représentatif de l'accumulateur ou du groupe d'accumulateurs, chaque cycle étant paramétré par des paramètres de fonctionnement de l'accumulateur, variables en fonction du temps, au cours des différents cycles ;
   - b) au cours des cycles de charge et de décharge, en différents instants de mesure (*t*), détermination de données expérimentales, comportant une valeur de chaque paramètre variable;
   - c) à partir des données expérimentales résultant de b), détermination de la fonction de vieillissement;

   le procédé étant **caractérisé en ce que** :

   - lors de l'étape a), les paramètres variables comprennent au moins l'état de charge (*SOC*(*t*)) et une profondeur de décharge (*DOD*(*t*)),
   - l'étape b) comporte, en différents instants de mesure (*t*) d'un même cycle, une détermination de la profondeur de décharge (*DOD*(*t*)), à partir d'une différence entre l'état de charge à l'instant de mesure (*SOC*(*t*)) et l'état de charge à un instant précédent l'instant de mesure (*SOC*(*t* - 1));
   - l'étape c) est mise en oeuvre par un algorithme d'optimisation, de façon à minimiser un écart entre :

     • la capacité ou la résistance du ou de chaque accumulateur de test en plusieurs instants de mesure ;
     • et une estimation de la capacité ou de la résistance du ou de chaque accumulateur de test, à chaque instant de mesure, par l'application de la fonction de vieillissement ;

   - de telle sorte que suite à l'étape c), les variables de la fonction de vieillissement comprennent au moins l'état de charge et la profondeur de décharge.

2. Procédé selon la revendication 1, dans lequel la fonction de vieillissement détermine :

   - une baisse de la capacité de l'accumulateur (*C*(*t*)), ou du groupe d'accumulateurs, au cours d'une utilisation de l'accumulateur ;
   - ou une augmentation de la résistance (*R*(*t*)) de l'accumulateur, ou du groupe d'accumulateurs, au cours de l'utilisation de l'accumulateur.

3. Procédé selon l'une quelconque des revendications précédentes, au cours duquel les variables de la fonction de vieillissement comprennent, outre la profondeur de décharge et l'état de charge : la température ($T(t)$) et/ou l'intensité de charge ou de décharge ($I(t)$) et/ou la charge totale échangée par l'accumulateur ($Q_{tot}(t)$).

**4.** Procédé selon la revendication 3, dans lequel les variables de la fonction de vieillissement sont au moins l'intensité de charge ou de décharge ($I(t)$), l'état de charge ($SOC(t)$) et la profondeur de décharge ($DOD(t)$).

**5.** Procédé selon l'une quelconque des revendications précédentes, dans lequel, les instants de mesure étant classés par ordre chronologique à partir d'un instant initial, l'étape b) comporte, pour chaque instant de mesure postérieur à deux instants de mesure suivant l'instant initial :

- comparaison de l'état de charge lors de l'instant de mesure ($t$) avec les états de charge respectifs lors de l'instant de mesure précédent ($t$ - 1) et l'avant-dernier instant de mesure ($t$ - 2);
- lorsque la comparaison indique que l'état de charge suit une évolution monotone, croissante ou décroissante, entre l'avant-dernier instant de mesure ($t$ - 2) et l'instant de mesure ($t$), incrémentation de la valeur de la profondeur de décharge ($DOD(t)$) à l'instant de mesure, en fonction de la valeur de la profondeur de décharge ($DOD(t - 1)$) à l'instant de mesure précédent ;
- lorsque la comparaison n'indique pas que l'état de charge suit une évolution monotone, croissante ou décroissante, entre l'avant-dernier instant de mesure et l'instant de mesure, réinitialisation de la valeur de la profondeur de décharge à l'instant de mesure.

**6.** Procédé selon l'une quelconque des revendications précédentes, dans lequel :

- les étapes a) et b) sont mises en oeuvre en utilisant successivement différents accumulateurs de test ;
- chaque cycle de charge/décharge s'étend entre une charge initiale ($SOC(t_{init})$), une charge finale ($SOC(t_{end})$), définissant une profondeur de décharge totale du cycle ($DOD_{tot}$);
- au moins deux accumulateurs de test différents sont soumis à des cycles de charge définissant une profondeur de décharge totale différente.

**7.** Procédé selon la revendication 6, dans lequel au moins deux accumulateurs de test différents sont soumis à des cycles de charge dont la charge initiale ($SOC(t_{init})$) et la charge finale ($SOC(t_{end})$), sont différentes.

**8.** Procédé d'estimation du vieillissement d'un accumulateur, le procédé comportant les étapes suivantes :

- i) détermination d'un modèle d'utilisation de l'accumulateur, le modèle d'utilisation définissant :
  - des cycles de charge et décharge de l'accumulateur durant une durée d'utilisation de l'accumulateur ;
  - des paramètres de fonctionnement de l'accumulateur au cours de chaque cycle ;
- ii) segmentation de la durée d'utilisation en instants d'estimation ($t'$);
- iii) détermination de paramètres de fonctionnement à chaque instant d'estimation ;
- iv) prise en compte d'une fonction de vieillissement ( $\frac{d(\Delta C)}{dQ_{tot}}$ , $\Delta C$) la fonction de vieillissement représentant une évolution de la capacité ou de la résistance de l'accumulateur en fonction de variables ;
- v) application successive de la fonction de vieillissement à chaque instant d'estimation (t') de façon à estimer une évolution de la capacité ou de la résistance de l'accumulateur sous l'effet du modèle d'utilisation ;

le procédé étant **caractérisé en ce que** :

- les variables de la fonction de vieillissement sont au moins l'état de charge ($SOC(t')$) et la profondeur de décharge ($DOD(t')$);
- l'étape iii) comporte un calcul de l'état de charge et de la profondeur de décharge à chaque instant d'estimation ;.
- la fonction de vieillissement est établie en mettant en oeuvre un procédé selon l'une quelconque des revendications 1 à 7

**9.** Procédé selon la revendication 8, dans lequel, les instants d'estimation sont classés par ordre chronologique à partir d'un instant d'estimation initial, le procédé comporte, lors de chaque instant d'estimation postérieur à deux instants d'estimation après l'instant initial :

- comparaison de l'état de charge lors de l'instant d'estimation avec les états de charge respectifs lors de l'instant d'estimation précédent (*t'* - 1) et l'avant-dernier instant d'estimation (*t'* - 2);
- lorsque la comparaison indique que l'état de charge suit une évolution monotone, croissante ou décroissante, entre l'avant-dernier instant d'estimation et l'instant d'estimation, incrémentation de la valeur de la profondeur de décharge à l'instant d'estimation (*DOD*(*t'*)), en fonction de la valeur de la profondeur de décharge à l'instant d'estimation précédent (*DOD*(*t'* - 1));
- lorsque la comparaison n'indique pas que l'état de charge suit une évolution monotone, croissante ou décroissante, entre l'avant-dernier instant d'estimation et l'instant d'estimation, réinitialisation de la valeur de la profondeur de décharge à l'instant d'estimation.

**10.** Dispositif de modélisation du vieillissement d'un accumulateur, le dispositif comportant une unité de traitement configurée pour :

- prendre en compte un modèle d'utilisation de l'accumulateur, le modèle d'utilisation définissant :

  • des cycles de charge et décharge de l'accumulateur durant une durée d'utilisation l'accumulateur ;
  • des paramètres de fonctionnement de l'accumulateur au cours de chaque cycle ;

- mettre en oeuvre les étapes ii) à v) d'un procédé selon l'une quelconque des revendications 8 ou 9.

## Patentansprüche

**1.** Verfahren zur Bestimmung einer Zyklisierungsalterungsfunktion ($\frac{d(\Delta C)}{dQ_{tot}}$, $\Delta C(t)$) eines Akkumulators (1) oder einer Akkumulatorengruppe, wobei die Zyklisierungsalterungsfunktion eine Entwicklung der Kapazität oder des Widerstands des Akkumulators oder der Akkumulatorengruppe im Laufe der Nutzung des Akkumulators oder der Akkumulatorengruppe ist, wobei die Zyklisierungsalterungsfunktion in Abhängigkeit von Variablen definiert wird, die für den Betrieb des Akkumulators repräsentativ sind, wobei das Verfahren umfasst:

- a) Ausführen von mehreren experimentellen Lade- und Entladezyklen mindestens eines Testakkumulators, der für den Akkumulator oder die Akkumulatorengruppe repräsentativ ist, wobei jeder Zyklus durch Betriebsparameter des Akkumulators parametriert wird, die im Laufe der verschiedenen Zyklen in Abhängigkeit von der Zeit variabel sind;
- b) im Laufe der Lade- und Entladezyklen, zu verschiedenen Messzeitpunkten (*t*), Bestimmen von experimentellen Daten, die einen Wert jedes variablen Parameters umfassen;
- c) ausgehend von den aus b) hervorgegangenen experimentellen Daten, Bestimmen der Alterungsfunktion;

wobei das Verfahren **dadurch gekennzeichnet ist, dass**:

- beim Schritt a) die variablen Parameter mindestens den Ladezustand *(SOC(t))* und eine Entladungstiefe (*DOD*(*t*)) umfassen,
- der Schritt b), zu verschiedenen Messzeitpunkten (*t*) eines selben Zyklus, ein Bestimmen der Entladungstiefe (*DOD*(*t*)) ausgehend von der Differenz zwischen dem Ladezustand zu dem Messzeitpunkt (*SOC*(*t*)) und dem Ladezustand zu einem vorhergehenden Messzeitpunkt (*SOC*(*t*- 1)) umfasst;
- der Schritt c) von einem Optimierungsalgorithmus so durchgeführt wird, dass eine Abweichung minimiert wird zwischen:

  • der Kapazität oder dem Widerstand des oder jedes Testakkumulators zu mehreren Messzeitpunkten;
  • und einer Schätzung der Kapazität oder des Widerstands des oder jedes Testakkumulators zu jedem Messzeitpunkt durch das Anwenden der Alterungsfunktion;

- so dass nach dem Schritt c) die Variablen der Alterungsfunktion mindestens den Ladezustand und die Entladungstiefe umfassen.

**2.** Verfahren nach Anspruch 1, wobei die Alterungsfunktion bestimmt:

- eine Abnahme der Kapazität des Akkumulators (*C*(*t*)) oder der Akkumulatorengruppe im Laufe einer Nutzung des Akkumulators;
- oder eine Zunahme des Widerstands ($R(t)$) des Akkumulators oder der Akkumulatorengruppe im Laufe einer Nutzung des Akkumulators.

**3.** Verfahren nach einem der vorhergehenden Ansprüche, in dessen Verlauf die Variablen der Alterungsfunktion neben der Entladungstiefe und dem Ladezustand umfassen: die Temperatur ($T(t)$) und/oder die Lade- oder Entladeintensität ($I(t)$) und/oder die von dem Akkumulator ausgetauschte Gesamtladung ($Q_{tot}(t)$).

**4.** Verfahren nach Anspruch 3, wobei die Variablen der Alterungsfunktion mindestens die Lade- oder Entladeintensität ($I(t)$), der Ladezustand ($SOC(t)$) und die Entladungstiefe ($DOD(t)$) sind.

**5.** Verfahren nach einem der vorhergehenden Ansprüche, wobei, wenn die Messzeitpunkte in chronologischer Reihenfolge ausgehend von einem Ausgangszeitpunkt geordnet sind, der Schritt b) für jeden Messzeitpunkt nach zwei auf den Ausgangszeitpunkt folgenden Messzeitpunkten umfasst:

- Vergleichen des Ladezustands zu dem Messzeitpunkt ($t$) mit den jeweiligen Ladezuständen zu dem vorhergehenden Messzeitpunkt ($t$- 1) und dem vorletzten Messzeitpunkt ($t$- 2);
- wenn der Vergleich ergibt, dass der Ladezustand einer monotonen, steigenden oder fallenden Entwicklung zwischen dem vorletzten Messzeitpunkt ($t$- 2) und dem Messzeitpunkt ($t$) folgt, Inkrementieren des Werts der Entladungstiefe ($DOD(t)$) zu dem Messzeitpunkt in Abhängigkeit von dem Wert der Entladungstiefe ($DOD(t$-1)) zu dem vorhergehenden Messzeitpunkt;
- wenn der Vergleich nicht ergibt, dass der Ladezustand einer monotonen, steigenden oder fallenden Entwicklung zwischen dem vorletzten Messzeitpunkt und dem Messzeitpunkt folgt, Reinitialisieren des Werts der Entladungstiefe zu dem Messzeitpunkt.

**6.** Verfahren nach einem der vorhergehenden Ansprüche, wobei:

- die Schritte a) und b) durchgeführt werden, indem nacheinander verschiedene Testakkumulatoren verwendet werden;
- jeder Lade-/Entladezyklus sich erstreckt zwischen einer Anfangsladung ($SOC(t_{init})$), einer Endladung ($SOC(t_{end})$), was eine Gesamtentladungstiefe des Zyklus ($DOD_{tot}$) definiert;
- mindestens zwei verschiedene Testakkumulatoren Ladezyklen unterzogen werden, die eine unterschiedliche Gesamtentladungstiefe definieren.

**7.** Verfahren nach Anspruch 6, wobei mindestens zwei verschiedene Testakkumulatoren Ladezyklen unterzogen werden, deren Anfangsladung ($SOC(t_{init})$) und Endladung ($SOC(t_{end})$) verschieden sind.

**8.** Verfahren zum Schätzen der Alterung eines Akkumulators, wobei das Verfahren die folgenden Schritte umfasst:

- i) Bestimmen eines Nutzungsmodells des Akkumulators, wobei das Nutzungsmodell definiert:

  • Lade- und Entladezyklen des Akkumulators während einer Nutzungsdauer des Akkumulators;
  • Betriebsparameter des Akkumulators im Laufe jedes Zyklus;

- ii) Segmentieren der Nutzungsdauer in Schätzzeitpunkte ($t'$);
- iii) Bestimmen von Betriebsparametern zu jedem Schätzzeitpunkt;
- iv) Berücksichtigen einer Alterungsfunktion ( $\frac{d(\Delta C)}{dQ_{tot}}, \Delta C$) , wobei die Alterungsfunktion eine Entwicklung der Kapazität oder des Widerstands des Akkumulators in Abhängigkeit von Variablen repräsentiert;
- v) sukzessives Anwenden der Alterungsfunktion auf jeden Schätzzeitpunkt ($t'$), so dass eine Entwicklung der Kapazität oder des Widerstands des Akkumulators unter der Einwirkung des Nutzungsmodells geschätzt wird;

wobei das Verfahren **dadurch gekennzeichnet ist, dass**:

- die Variablen der Alterungsfunktion mindestens der Ladezustand ($SOC(t')$) und die Entladungstiefe ($DOD(t')$) sind;
- der Schritt iii) eine Berechnung des Ladezustands und der Entladungstiefe zu jedem Schätzzeitpunkt umfasst;.

- die Alterungsfunktion ermittelt wird, in dem ein Verfahren nach einem der Ansprüche 1 bis 7 durchgeführt wird.

**9.** Verfahren nach Anspruch 8, wobei, wenn die Schätzzeitpunkte in chronologischer Reihenfolge ausgehend von einem Ausgangsschätzzeitpunkt geordnet sind, das Verfahren bei jedem Schätzzeitpunkt nach zwei auf den Ausgangszeitpunkt folgenden Schätzzeitpunkten umfasst:

- Vergleichen des Ladezustands zu dem Schätzzeitpunkt mit den jeweiligen Ladezuständen zu dem vorhergehenden Schätzzeitpunkt (*t'*- 1) und dem vorletzten Schätzzeitpunkt (*t'* - 2);
- wenn der Vergleich ergibt, dass der Ladezustand einer monotonen, steigenden oder fallenden Entwicklung zwischen dem vorletzten Schätzzeitpunkt und dem Schätzzeitpunkt folgt, Inkrementieren des Werts der Entladungstiefe zu dem Schätzzeitpunkt (*DOD*(*t'*)) in Abhängigkeit von dem Wert der Entladungstiefe zu dem vorhergehenden Schätzzeitpunkt (*DOD*(*t'*- 1));
- wenn der Vergleich nicht ergibt, dass der Ladezustand einer monotonen, steigenden oder fallenden Entwicklung zwischen dem vorletzten Schätzzeitpunkt und dem Schätzzeitpunkt folgt, Reinitialisieren des Werts der Entladungstiefe zu dem Schätzzeitpunkt.

**10.** Vorrichtung zur Modellierung der Alterung eines Akkumulators, wobei die Vorrichtung eine Verarbeitungseinheit umfasst, die dazu ausgestaltet ist:

- ein Nutzungsmodell des Akkumulators zu berücksichtigen, wobei das Nutzungsmodell definiert:

  • Lade- und Entladezyklen des Akkumulators während einer Nutzungsdauer Akkumulators;
  • Betriebsparameter des Akkumulators im Laufe jedes Zyklus;

- die Schritte ii) bis v) eines Verfahrens nach einem der Ansprüche 8 oder 9 durchzuführen.

## Claims

**1.** A method for determining an ageing function ( $\frac{d(\Delta C)}{dQ_{tot}}$ , $\Delta C(t)$) of an accumulator (1), or of a group of accumulators, the ageing function representing a variation in the capacity or resistance of the accumulator, or of the group of accumulators, as a function of variables representative of the operation of the accumulator, the method comprising:

- a) carrying out a plurality of experimental cycles of charging and discharging at least one test accumulator representative of the accumulator or of the group of accumulators, each cycle being parameterised by accumulator operating parameters that vary as a function of time during the various cycles;
- b) during the charging and discharging cycles, at various measurement times (t), determining experimental data comprising a value of each variable parameter;
- c) on the basis of the experimental data resulting from b), determining the ageing function;

wherein:

- in step a), the variable parameters comprise at least the state of charge (*SOC*(*t*)) and a depth of discharge (*DOD*(*t*));
- step b) comprises determining a depth-of-discharge value (*DOD*(*t*)), at various measurement times (*t*) of a given cycle, from a difference between the state of charge at the measurement time and the state of charge (*SOC*(*t*)) at a preceding measurement time (*SOC*(*t* - 1));
- c) is implemented by an optimisation algorithm, so as to minimise a deviation between:

  • the capacity or resistance, of the or of each test accumulator, at a plurality of measurement times;
  • and an estimate, determined by applying the ageing function, of the capacity or resistance of the or of each test accumulator at each measurement time.

- such that, following step c), the variables of the ageing function comprise at least the state of charge and the depth of discharge.

**2.** The method according to Claim 1, wherein the ageing function determines:

- a decrease in the capacity of the accumulator ($C(t)$), or of the group of accumulators, during a use of the accumulator;
- or an increase in the resistance of the accumulator, ($R(t)$), or of the group of accumulators, during the use of the accumulator.

**3.** The method according to any one of the preceding claims, wherein the variables of the ageing function comprise, apart from the depth of discharge and the state of charge: temperature ($T(t)$) and/or charging or discharging current ($I(t)$) and/or the total charge exchanged by the accumulator ($Q_{tot}(t)$).

**4.** The method according to any one of the preceding claims, wherein the variables of the ageing function are at least the charging or discharging current ($I(t)$), the state of charge ($SOC(t)$) and the depth of discharge ($DOD(t)$).

**5.** The method according to any one of the preceding claims, wherein the measurement times are classified in chronological order from an initial time, step b) further comprising, for each measurement time subsequent to two measurement times following the initial time:

- comparing the state of charge at the measurement time ($t$) with the respective states of charge at the preceding measurement time ($t$ - 1) and the penultimate measurement time ($t$ - 2);
- when the comparison indicates that the state of charge varies monotonically, upwards or downwards, between the penultimate measurement time ($t$ - 2) and the measurement time (t), incrementing the value of the depth of discharge at the measurement time ($DOD(t)$), depending on the value of the depth of discharge at ($DOD(t - 1)$) the preceding measurement time;
- when the comparison does not indicate that the state of charge varies monotonically, upwards or downwards, between the penultimate measurement time and the measurement time, resetting the value of the depth of discharge at the measurement time.

**6.** The method according to any one of the preceding claims, wherein:

- steps a) and b) are implemented using successively different test accumulators;
- each charging/discharging cycle extends between an initial charge ($SOC(t_{init})$), and a final charge ($SOC(t_{end})$), defining a depth of discharge of the cycle ($DOD_{tot}$);
- at least two different test accumulators are subjected to charging cycles defining a different total depth of discharge.

**7.** The method according to Claim 6, wherein at least two different test accumulators are subjected to charging cycles the initial charge ($SOC(t_{init})$) and the final charge ($SOC(t_{end})$) of which are different.

**8.** A method for estimating the ageing of an accumulator, comprising:

- i) determining a model of use of the accumulator, the model of use defining:

  • cycles of charging and discharging the accumulator during a duration of use of the accumulator;
  • operating parameters of the accumulator during each cycle;

- ii) segmenting the duration of use into estimation times ($t'$);
- iii) determining operating parameters at each estimation time;
- iv) taking into account an ageing function ( $\frac{d(\Delta C)}{dQ_{tot}}$ , $\Delta C$), the ageing function representing a variation in the capacity or in the resistance of the accumulator as a function of variables;
- v) successively applying the ageing function at each estimation time ($t'$) so as to estimate a variation in the capacity or in the resistance of the accumulator under the effect of the model of use;

wherein:

- the variables of the ageing function are at least the state of charge ($SOC(t')$) and the depth of discharge ($DOD(t')$);
- step iii) comprises computing the state of charge and the depth of discharge at each estimation time;
- the ageing function is established by implementing a method according to any one of claims 1 to 7

**9.** The method according to Claim 8, wherein, the estimation times are classified in chronological order from an initial estimation time, the method further comprising, at each estimation time subsequent to two estimation times after the initial time:

- comparing the state of charge at the estimation time with the respective states of charge at the preceding estimation time (*t'* - 1) and the penultimate estimation time (*t'* - 2);
- when the comparison indicates that the state of charge varies monotonically, upwards or downwards, between the penultimate estimation time and the estimation time, incrementing the value of the depth of discharge at the estimation time (*DOD*(*t'*)), depending on the value of the depth of discharge at the preceding estimation time (*DOD*(*t'* - 1));
- when the comparison does not indicate that the state of charge varied monotonically, upwards or downwards, between the penultimate estimation time and the estimation time, resetting the value of the depth of charge at the estimation time.

**10.** A device for modelling the ageing of an accumulator, the device comprising a processing unit configured to:

- take into account a model of use of the accumulator, the model of use defining:

  • cycles of charging and discharging the accumulator during a duration of use of the accumulator;
  • operating parameters of the accumulator during each cycle;

- implement steps ii) to v) of a method according to any one of claims 8 or 9.

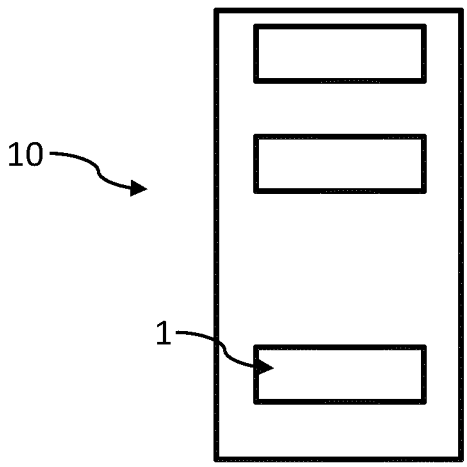


Fig. 1A

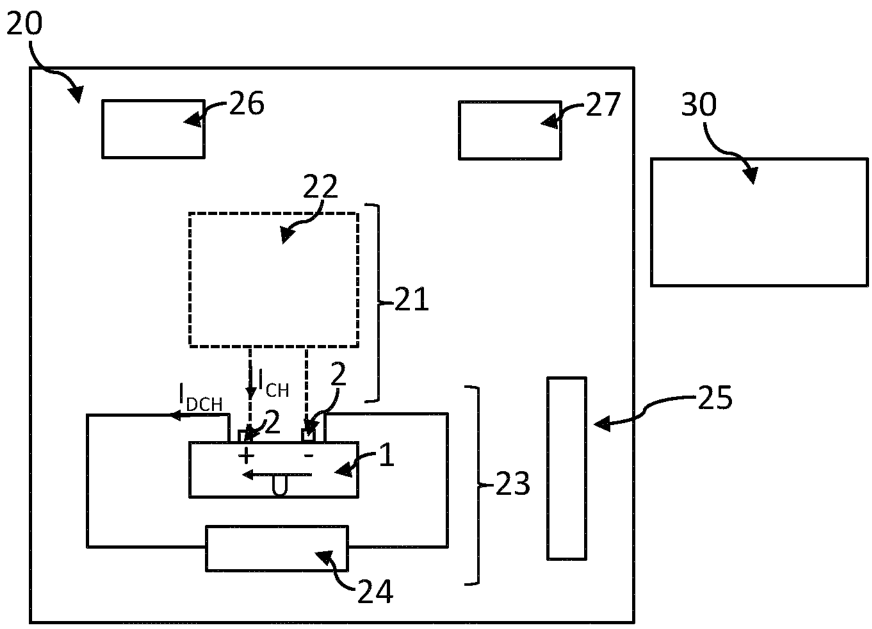


Fig. 1B

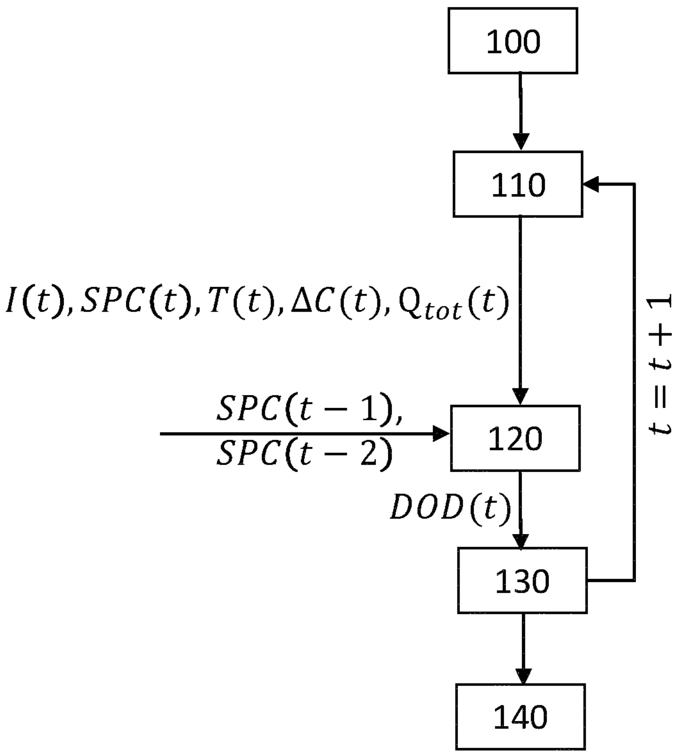
100
110
$I(t), SPC(t), T(t), \Delta C(t), Q_{tot}(t)$
$t = t + 1$
$SPC(t-1)$,
$SPC(t-2)$
120
$DOD(t)$
130
140

**Fig. 2A**

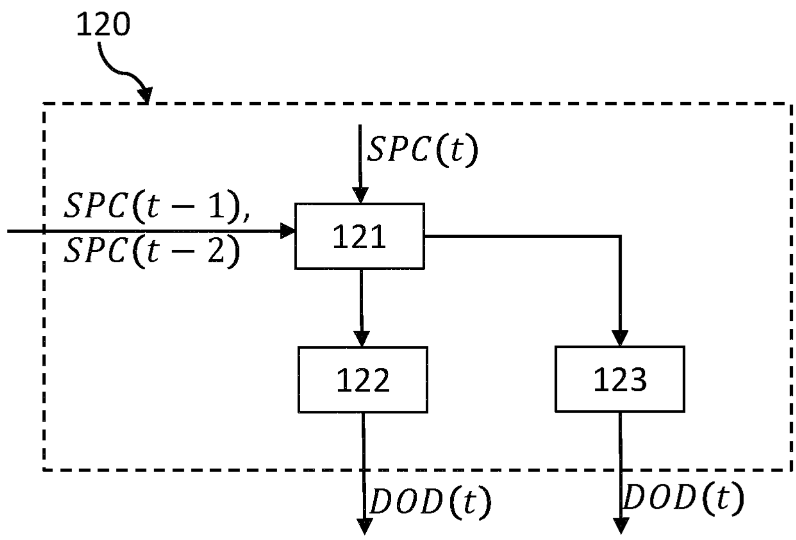
120
$SPC(t)$
$SPC(t-1)$,
$SPC(t-2)$
121
122
123
$DOD(t)$
$DOD(t)$

**Fig. 2B**

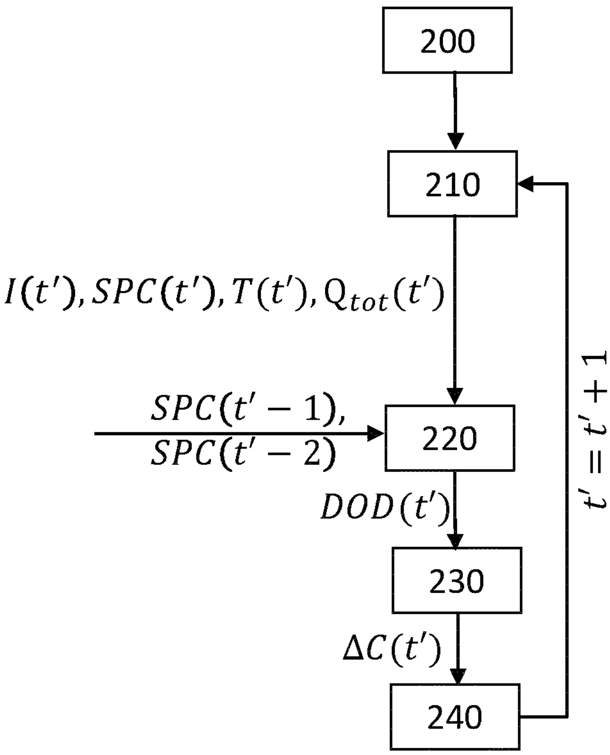
200
210
$I(t'), SPC(t'), T(t'), Q_{tot}(t')$
$SPC(t'-1),$
$SPC(t'-2)$
220
$DOD(t')$
230
$\Delta C(t')$
240
$t' = t' + 1$

Fig. 2C

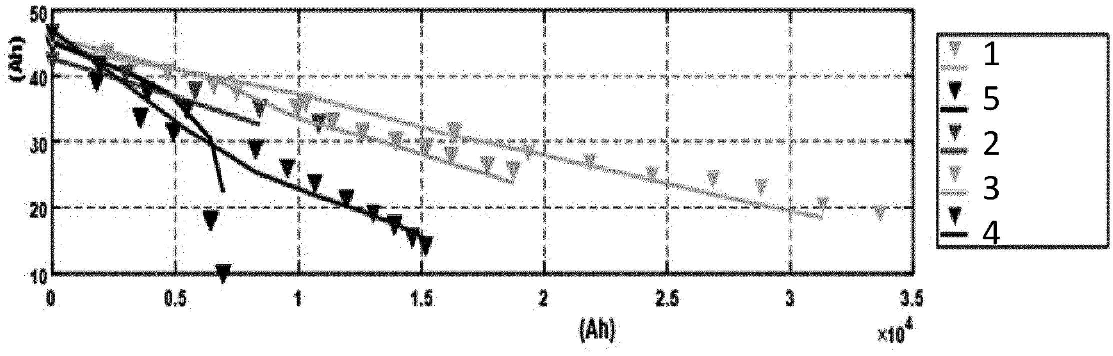


Fig. 3A

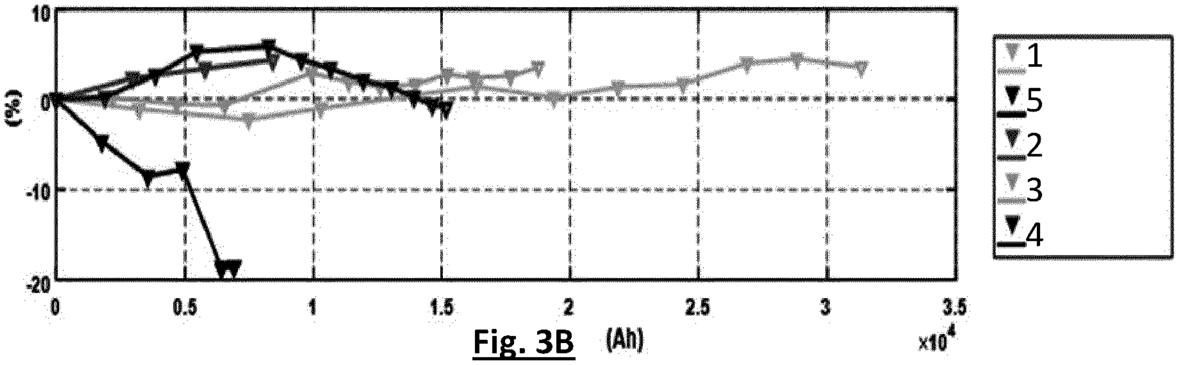


Fig. 3B

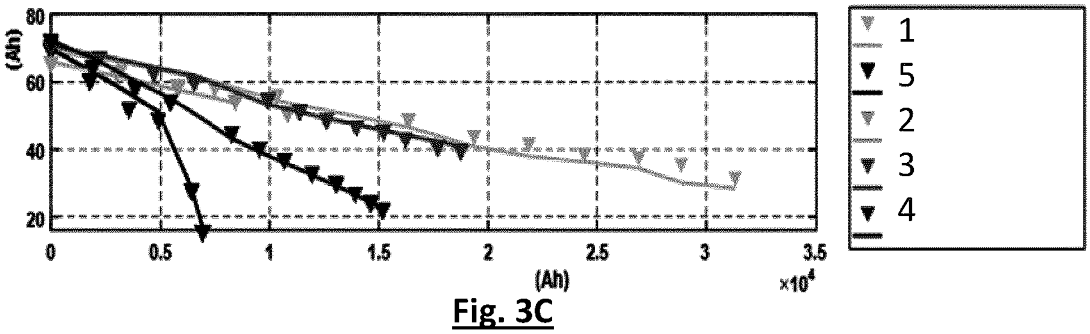


Fig. 3C

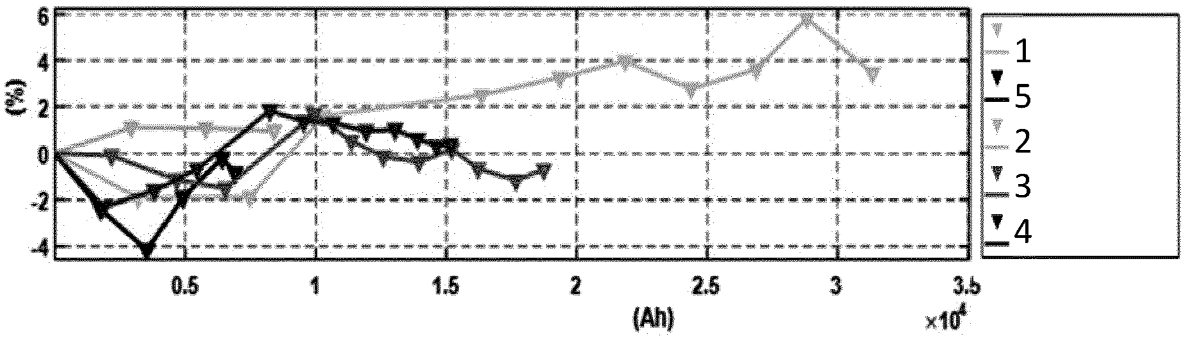


Fig. 3D

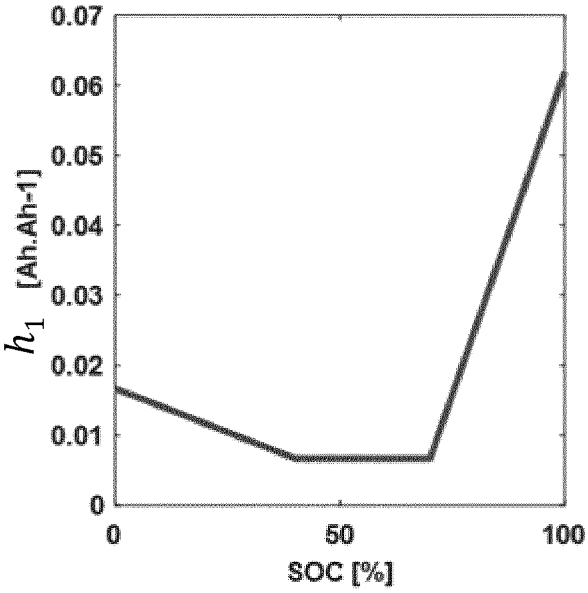
0.07
0.06
0.05
0.04
0.03
0.02
0.01
0
$h_1$ [Ah.Ah-1]
0
50
100
SOC [%]

Fig. 4A

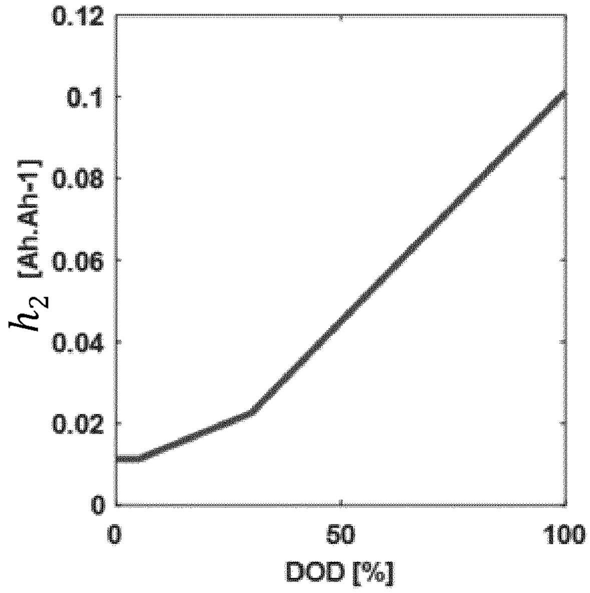
0.12
0.1
0.08
0.06
0.04
0.02
0
$h_2$ [Ah.Ah-1]
0
50
100
DOD [%]

Fig. 4B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 8332342 B
- US 2010121587 A
- DE 19540827


### Littérature non-brevet citée dans la description


- **GEWALD T.** Accelerated aging characterization of Lithium-ion cells : using sensitivity analysis to identify the stress factors relevant to cyclic aging. *Batteries,* 2020, vol. 6, 6
- **SARAKESTA-ZABALA.** Cycle ageing analysis of a LiFePO4/graphite cell with dynamic model validations : towards realistic lifetime prédictions. *Journal of power sources,* 2015, vol. 275, 573-587